Europäisches Patentamt

European Patent Office

Office européen des brevets

(11) Publication number: **0 427 327 A1**

# EUROPEAN PATENT APPLICATION

(21) Application number: 90202898.4

(51) Int. Cl.⁵: **H01L 21/321**

(22) Date of filing: 02.11.90

(30) Priority: 07.11.89 NL 8902744

(43) Date of publication of application:
15.05.91 Bulletin 91/20

(84) Designated Contracting States:
**DE FR GB IT NL**

(71) Applicant: **N.V. Philips' Gloeilampenfabrieken
Groenewoudseweg 1
NL-5621 BA Eindhoven(NL)**

(72) Inventor: **Van Delden, Martinus Hermanus
Wilhelmus Maria
c/o INT. OCTROOIBUREAU B.V. Prof.
Holstlaan 6
NL-5656 AA Eindhoven(NL)**
Inventor: **Van Houtum, Hendrikus Josephus
Wilhelmus
c/o INT. OCTROOIBUREAU B.V. Prof.
Holstlaan 6
NL-5656 AA Eindhoven(NL)**

(74) Representative: **Rensen, Jan Geert et al
Internationaal Octrooibureau B.V. Prof.
Holstlaan 6
NL-5656 AA Eindhoven(NL)**

(54) Method of providing aluminium or aluminium alloy tracks on a substrate.

(57) When aluminium tracks are provided on a substrate by first providing on a substrate a layer of aluminium, and then removing this layer in a certain pattern by plasma etching in a chlorine-containing atmosphere, it is found that chlorine residues remaining on the substrate promote corrosion of the aluminium tracks. Rinsing in water turns out to remove these chlorine residues insufficiently. If immediately after plasma etching in a chlorine-containing atmosphere the product obtained is exposed to a plasma in a nitrogen-containing atmosphere, chlorine residues can subsequently be removed by rinsing with water, which is found to improve effectively the corrosion assistance of the aluminium tracks.

EP 0 427 327 A1

## METHOD OF PROVIDING ALUMINIUM OR ALUMINIUM ALLOY TRACKS ON A SUBSTRATE.

FIELD OF THE INVENTION

The invention relates to a method of providing aluminium or aluminium alloy tracks on a substrate, by which the surface of a body is provided with a metal layer comprising aluminium which is locally covered with a photoresist pattern and then etched in a plasma comprising chlorine, upon which the etched surface is rinsed with water.

In this method, the object of the water rinse is to remove chlorine residues which during plasma etching become attached to the photoresist layer, to any protective layers on the lateral edges of the etched metal tracks formed from constitutents of the plasma atmosphere, and to the exposed metal parts. Such chlorine residues can promote the corrosion of metal tracks made of aluminium or an aluminium alloy upon exposure to the atmosphere. In particular metal tracks made of an alloy of aluminium with silicon and copper, for example Al-Sil-Cu2, and tracks made of aluminium and aluminium alloys which are in contact with layers comprising nobler metals than aluminium have a poor resistance to corrosion.

The invention is of particular importance in the manufacture of a semiconductor device provided with metal tracks made of aluminium to which smaller or less small quantities of other elements, such as copper and silicon, have been added. Such tracks usually have small dimensions. Corrosion of these tracks can very quickly lead to bad operation or total failure of the semiconductor device.

BACKGROUND OF THE INVENTION

Proc. Electrochem. Soc. 83 , pp. 341-352 (1983) describes a research into the suppression of corrosion of plasma-etched aluminium. A number of possible after-treatments are compared in this publication. An after-treatment with a plasma containing fluorohydrocarbon leads to a clear improvement in the resistance to corrosion compared with rinsing with water, probably also thanks to the formation of a protective polymer film on the etched surface. An aftertreatment with a plasma in other gases, especially in a nitrogen-containing plasma, however, turns out to give no essential improvement. The Applicant's own research demonstrated that chlorine-containing constituents which adhere to the photoresist layer and possibly to other surfaces are not completely removed by treatment with a nitrogen-containing plasma or by rinsing with water. Chlorine ions are only removed upon treatment with a fluorine-containing plasma without the formation of a protective polymer film, chlorine ions being probably replaced by fluorine ions in that case.

SUMMARY OF THE INVENTION

The invention has for its object to provide a method by which chlorine-containing constituents adhering to the photoresist layer and possibly to other surfaces can be removed, while the use of a fluorine-containing plasma can be avoided.

It was found that this object can be achieved by means of a method as described in the opening paragraph, characterized in that after the etched surface is exposed to a nitrogen-containing plasma plasma etching in a chlorine-containing atmosphere, but before rinsing with water.

Upon application of the invented method, it appears that chlorine ions are effectively removed without being replaced by other environmentally noxious substances, such as fluorine ions. It is suspected that the treatment with a nitrogen-containing plasma brings the chlorine-containing constituents, which during plasma etching have become attached to the photoresist layer and possibly to other surfaces, and which are mainly responsible for the corrosion of the etched-out metal tracks comprising aluminium upon exposure to the atmosphere, into such a form that chlorine ions can be removed by rinsing with water.

The treatment with the nitrogen-containing plasma preferably takes place in an atmosphere of flowing nitrogen. The suitable flowrate was found to be between 25 and 100 sccm for a reactor volume of approximately 10 litres. The required flowrate, however, depends on the reactor volume. The general principle is: the greater the reactor, the greater the required flowrate. Flowrate values in excess of approximately 50 sccm, however, would seem to be improbable.

DESCRIPTION OF EMBODIMENTS

The invented method will now be explained in more detail with reference to the following embodiment.

The basic material for applying an aluminium alloy layer was a disc-shaped body of p-type Si each time, coated with a layer of thermally grown silicon oxide with a thickness of 6000 A. The silicon oxide layer was cleaned with fuming nitric acid, rinsed with water, and dried before the desired layer of aluminium alloy with a thickness of 0,5-2,5 mm was provided by sputtering. If desired, an intermediate layer of TiW, Ti or Co is applied on the substrate, also by sputtering, before the aluminium alloy layer is provided. Such intermediate layers may be used as diffusion barriers in semiconductor devices. The aluminium alloys used in the present embodiment were: AlSi < 1% Si by weight > and AlSiCu < 1% Si by weight, 2% Cu by weight >. After the aluminium alloy layer was applied, it was cleaned with fuming nitric acid, rinsed with water, and dried. A photoresist (HPR 204) layer with a thickness of 1,3 $\mu$m was subsequently applied, irradiated in a pattern with UV-light and developed. Plasma etching took place in an atmosphere containing 5-30 vol.% $CHCl_3$, 20-50 vol.% $Cl_2$, 5-25 vol.% $BCl_3$ and 20-35 vol.% $N_2$, a protective polymer film being provided on the side edges of the etched-out metal tracks in such an atmosphere. The exact composition of the etching atmosphere depends on the parameters of the etching machine used; a suitable etching atmosphere turned out to have the following composition: 20 vol.% $CHCl_3$, 25 vol.% $Cl_2$, 20 vol.% $BCl_3$ and 35 vol.% $N_2$.

The after-treatment with a plasma in a gas of different composition from the etching gas took place immediately following the etching treatment, without the samples being exposed to the atmosphere. after-treatments with a plasma in gases of various compositions were carried out for the sake of comparison. Rinsing with distilled water then took place by spraying the samples with water and rotating them. Each sample was then dried by rotation in dry nitrogen for fifteen seconds at a rate of 5000 rpm.

The progress of the corrosion process in the air was visually monitored. The time interval between the end of the after-treatment and the visually discernible formation of brown stains on a previously defined pattern comprising a comparatively large quantity of photoresist per $cm^2$ substrate surface area with photoresist coating was determined as a measure of the corrosion resistance. This time interval is given as Tcorr. in the tables below.

A number of tests were made without plasma after-treatments for the sake of comparison, possibly followed by rinsing with water. The results of these tests are given in table 1.

TABLE 1

| No. | Al-alloy | Substrate | After-Treatment | Tcorr. |
|---|---|---|---|---|
| 1 | Al(Si) | $SiO_2$ | none | 2 weeks |
| 2 | Al(Si) | $SiO_2$ | water rinse | > 3 months |
| 3 | Al(Si) | TiW | none | 2 minutes |
| 4 | Al(Si) | TiW | water rinse | 1 hour |
| 5 | Al(Si) | TiW etched | none | 1-2 hours |
| 6 | Al(si) | TiW etched | water rinse | 2-3 weeks |
| 7 | Al(Si,Cu) | $SiO_2$ | none | 5-10 minutes |
| 8 | Al(Si,Cu) | $SiO_2$ | water rinse | 30-60 minutes |
| 9 | Al(Si,Cu) | TiW | none | < 10 seconds |
| 10 | Al(Si,Cu) | TiW | water rinse | 15-45 minutes |
| 11 | Al(Si,Cu) | TiW etched | none | < 5 minutes |
| 12 | Al(Si,Cu) | TiW etched | water rinse | 2-5 hours |

A comparison of the various Tcorr. measurements shows that corrosion occurs most quickly in the case of AlSiCu alloy tracks on non-etched TiW layer.

Table 2 summarizes the results of a number of tests with etched AlSiCu on a non-etched TiW layer. The plasma treatment was applied during sixty seconds at a pressure of 1 torr, 250 Watts, and a flowrate of the gas atmosphere of 25 sccm. Rinsing with water and drying took place as in the tests summarized in table 1.

3

TABLE 2

| No. | Al-alloy | Substrate | Plasma Treatment | Tcorr. |
|---|---|---|---|---|
| 13 | Al(Si,Cu) | TiW | $N_2$ | > 44 hours |
| 14 | Al(Si,Cu) | TiW | $O_2$ | > 8 hours |
| 15 | Al(Si,Cu) | TiW | $CF_4/O_2$ (5-20vol.%) | > 12 hours |
| 16 | Al(Si,Cu) | TiW | $CF_4$ | > 28 hours |
| 17 | Al(Si,Cu) | TiW | $NH_3$ | > 44 hours |

It is apparent from table 2 that the effect of a plasma treatment in $N_2$ is not essentially different from that of an aftertreatment in $NH_2$, which is why the following tests were carried out with $N_2$ for the sake of simplicity, pressure 1 torr, 375 Watts, flowrate 100 sccm. The effects of plasma treatments with and without water rinsing are compared in table 3. Rinsing with water, if applicable, took place in the manner as described above.

TABLE 3

| No. | Al-alloy | Substrate | After-Treatment | Tcorr. |
|---|---|---|---|---|
| 18 | Al(Si) | $SiO_2$ | $N_2$ | > 2 weeks |
| 19 | Al(Si) | $SiO_2$ | $N_2$ + rinse | > 3 weeks |
| 20 | Al(Si) | TiW | $N_2$ | 10 minutes |
| 21 | Al(Si) | TiW | $N_2$ + rinse | 3 weeks |
| 22 | Al(Si,Cu) | $SiO_2$ | $N_2$ | 30 minutes |
| 23 | Al(Si,Cu) | $SiO_2$ | $N_2$ + rinse | > 3 weeks |
| 24 | Al(Si,Cu) | TiW | $N_2$ | 5-10 minutes |
| 25 | Al(Si,Cu) | TiW | $N_2$ + rinse | > 3 weeks |

The effect of the invented method is apparent in a clear increase in Tcorr. compared with a treatment with exclusively a nitrogen-containing plasma or exclusively rinsing with water (compare table 1), specially in those situations where the risk of corrosion is greatest intermediate TiW layer, use of Al(Si, Cu) tracks).

It should be noted that among the experiments listed in tables 1-3 the Nos. 13, 17, 19, 21, 23 and 25 represent embodiments if the invented method for which exclusive rights are claimed in the subsequent claims. The remaining experiments are included for the sake of comparison only.

**Claims**

1. A method of providing aluminium or aluminium alloy tracks on a substrate, by which the surface of a body is provided with a metal layer comprising aluminium which is locally covered with a photoresist pattern and then etched in a plasma comprising chlorine, upon which the etched surface is rinsed with water, characterized in that the etched surface is exposed to a nitrogen-containing plasma after plasma etching, but before rinsing with water.

2. A method as claimed in Claim 1, characterized in that the etched surface is exposed to a nitrogen-containing plasma immediately after plasma etching, without intervening exposure to the atmosphere.

3. A method as claimed in any one of the preceding Claims, characterized in that the etched surface is exposed to a plasma which is generated in an atmosphere of flowing nitrogen.

4. A method as claimed in Claim 3, characterized in that the flowrate of the nitrogen is between 25 and 100 sccm.

5. A method of manufacturing a semiconductor device provided with tracks etched from aluminium or an aluminium alloy in a chlorine-containing atmosphere, characterized in that the tracks are provided by the use of a method as claimed in one or several of the preceding claims 1-4.

4

European
Patent Office

# EUROPEAN SEARCH REPORT

Application Number

**EP 90 20 2898**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,A | US-A-4 370 195 (HALON ET.AL.) * the whole document * * the whole document * | 1,2-5 | H 01 L 21/321 |
| A | SOLID STATE TECHNOLOGY. vol. 24, no. 4, April 1981, WASHINGTON US pages 189 - 194; D.W. HESS: "PLASMA ETCHING OF ALUMINIUM" | | |
| A | IBM TECHNICAL DISCLOSURE BULLETIN. vol. 24, no. 11B, April 1982, NEW YORK US page 6001 H.R. POTTS: "PLASMA CORROSION INHIBITION" | | |

|  | TECHNICAL FIELDS SEARCHED (Int. Cl.5) |
|---|---|
|  | H 01 L 21 |

The present search report has been drawn up for all claims

| Place of search | Date of completion of search | Examiner |
|---|---|---|
| The Hague | 18 February 91 | PHEASANT N.J. |